# EUROPEAN PATENT SPECIFICATION

(11) **EP 0 251 567 B1**
(45) Date of publication and mention of the grant of the patent: **08.09.1993**
(21) Application number: 87305360.7
(22) Date of filing: 17.06.1987
(51) Int. Cl.: C23F 1/00, C23C 14/24, C23C 14/34, H01L 21/203, H01J 37/34, H03B 9/00

(54) **Dry process apparatus**
Vorrichtung für ein Trockenverfahren
Appareil pour un procédé par voie sèche

(30) Priority: 23.06.1986 JP 146501/86; 31.10.1986 JP 258535/86; 29.01.1987 JP 17148/87
(43) Date of publication of application: 07.01.1988
(73) Proprietor: Oki Electric Industry Company, Limited, Tokyo 105 (JP)
(72) Inventor: Kinoshita, Haruhisa, Minato-ku Tokyo (JP)
(74) Representative: SERJEANTS

(56) References cited:
- EP-A- 0 136 450
- EP-A- 0 154 158
- EP-A- 0 162 642
- EP-A- 0 162 643
- EP-A- 0 163 445
- EP-A- 0 168 446
- EP-A- 0 173 164
- AT-B- 378 971
- DD-A- 2 305 565
- DE-A- 3 206 413
- DE-A- 3 322 680
- DE-A- 3 434 698

## Description

The invention relates to magnetron-discharge enhanced dry process apparatus.

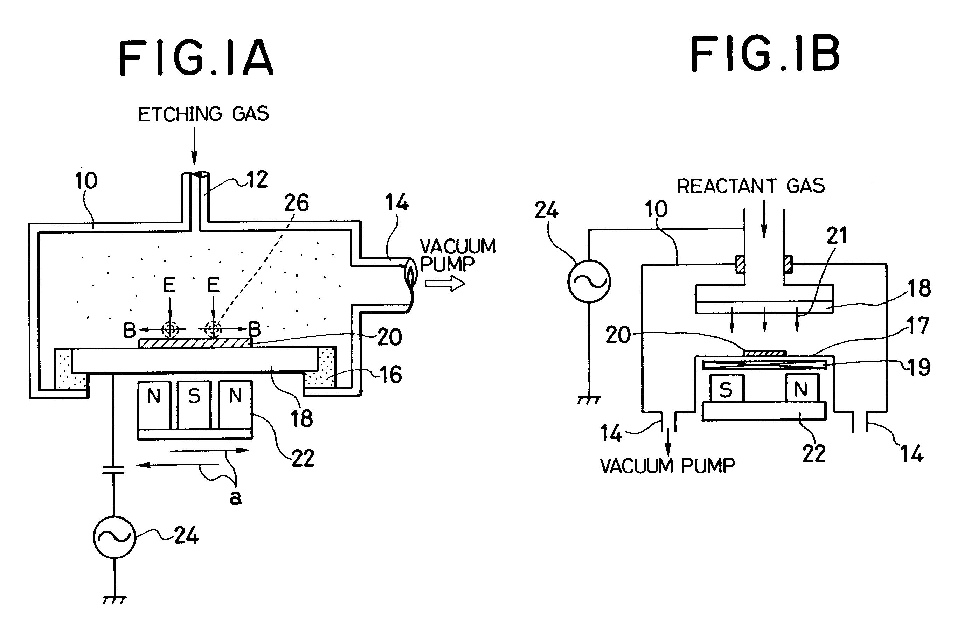

A prior art dry process apparatus is described in the Japanese Journal of Applied Physics. Vol. 20, No. 11, 1981, pp. L 817-820, and Extended Abstracts of the 18th Conference on Solid State Devices and Materials, Tokyo, 1986, pp. 495-498. Schematic diagrams of the apparatus described in these papers are shown in Figures 1A and 1B. In Figure 1A the material to be processed is situated on the cathode: in Figure 1B it is situated on the anode.

The apparatus in Figure 1A comprises a reactor 10 with an etching gas inlet and an outlet 14 leading to a vacuum pump. Part of the floor of the reactor 10 is a cathode 18 fitted to a nonconductive section 16 made of a dielectric material such as Teflon (Registered Trade Mark). The material to be etched (which is hereinafter referred to as the substrate) 20 is placed onto the cathode 18 inside the reactor 10. Outside the reactor 10, under the substrate 20 and parallel to it, is a permanent magnet assembly 22 which presents in sequence N-, S-, and N- poles toward the substrate. This assembly 22 is scanned in a reciprocating horizontal motion along arrows a parallel to the substrate 20. A high frequency (rf) oscillator 24 (including a power supply and having an oscillation frequency of 13.56MHz) acts as a source of electromagnetic radiation for the cathode 18.

After the substrate 20 is placed onto the cathode 18 the reactor 10 is evacuated and etching gas is introduced at a pressure of 1.32 Pa to 0.132 Pa (10⁻² to 10⁻³ Torr); then electromagnetic waves are applied to the cathode 18 by the rf oscillator 24, thereby ionizing the etching gas to create a plasma of positive ions and negative electrons. The electromagnetic waves generate an alternating electric field E oriented perpendicularly to the cathode 18. The assembly 22 generates a magnetic field B parallel to the cathode 18 in the positions between the N- and S-poles. Intersecting orthogonally in the space above the substrate 20, the alternating electric field E and magnetic field B cause the lightweight electrons to spiral along the lines of magnetic force in a tight cyclotron motion during which they collide high-energy with the neutral etching gas, thereby generating a high-density plasma which induces a magnetron discharge 26 in this region.

The apparatus of the prior art shown in Figure 1B comprises a reactor 10 from which air can be evacuated, an anode 17 to which is secured a substrate 20 on which vapor is to be deposited, a cathode 18 connected to an rf oscillator 24 (with a frequency of 13.56MHz), a permanent magnet assembly 22 for inducing a magnetron discharge, a heater 19 for heating the vapor deposition substrate 20, and a reactant gas 21 for the vapor-deposition of a thin film. The apparatus deposits a film of a material such as aluminium on the substrate 20 as follows. First the reactor 10 is evacuated then a reactant gas 21 is introduced at a pressure of 304 Pa (2.3 Torr), and 13.56 MHz high-frequency power is applied to the cathode 18 from the rf oscillator 24, ionizing the reactant gas 21 to create a plasma of positive ions and negative electrons. The applied electromagnetic waves also generate an alternating electric field oriented perpendicularly to the anode 17, while the assembly 22, which comprises two permanent bar magnets, creates a magnetic field parallel to the anode between the N and S magnetic poles. A magnetron discharge is induced as described for Figure 1A.

The ionization rate of a normal rf discharge of the etching gas or reactant gas is only about 10⁻⁴. The ionization rate of a magnetron discharge is about 10⁻², at least two orders of magnitude better, and the etch rate is improved by at least one order of magnitude. Moreover, there is improvement in both the deposition rate and the quality of the resulting film.

A problem in the prior art as shown in Figure 1A is that the magnetic field B created above the material to be etched (e.g. the substrate 20) is non-uniform. Uniform substrate etching can be achieved only by reciprocating the permanent magnet assembly 22 back and forth with respect to the substrate, but the magnetron discharge 26 also moves horizontally. This motion reduces the mean etch rate.

To mitigate this two independent magnets have been used with the N-pole of one magnet facing the S-pole of the other. Although a more uniform magnetic field can so be produced, great skill and effort are demanded, and the apparatus requires extra space which is structurally disadvantageous.

A similar problem arises with Figure 1B. The pair of bar magnets in the assembly 22 creates a non-uniform magnetic field and vapor cannot be deposited uniformly on the substrate unless the assembly 22 is rotated horizontally. The pair of bar magnets also takes up considerable space.

The invention provides plasma discharge dry process apparatus having a reactor in which an electric field can be generated by a pair of electrodes for processing material mounted on one of the electrodes, for example for etching, sputtering or depositing a thin film, and means are provided for generating a magnetic field interacting with the electrical field to induce magnetron discharge to aid processing of the material; characterised in that the magnetic field generating means comprises a continuous or substantially continuous loop of permanently magnetized material having a N-pole in one half and a S-pole in the other half with the poles arranged so as to generate substantially parallel field lines extending across the central loop gap.

Advantageously the poles are arranged so as to generate substantially parallel field lines extending across the central ring gap and the ring is continuous, optionally circular, elliptical or angular and the respective poles are formed on transversely spaced ends of the ring, preferably on diametrically opposed ends. A uniform magnetic field can be formed above the material to be processed and the permanent magnet assembly need not be moved parallel to the material providing uniform processing of the materials. A uniform film may be formed by a chemical vapor-deposition. The material may be situated on the cathode or on the anode.

The magnet ring need hence not be circular. The permanent magnet ring has an N-pole in one half of the ring and an S-pole in the other half of the ring. Lines of magnetic force extending from the N-pole to the S-pole are created in the vacant space within the ring and in the adjoining space.

The permanent magnet ring may be mounted inside or outside the reactor. The mounting need not permit rotating or scanning reciprocating motion, parallel to the material to be processed, but preferably the magnet is mounted so that it can be rotated with its magnetic field by suitable means in a plane parallel to the surface of the material. The permanent magnet ring can generate a magnetic field in the space above, preferably parallel to the material to be processed and in particular in the region in which a magnetron discharge is desired. In any event the magnet ring and the material to be processed can be positioned at relative heights or at the same height, but when viewed from above, the material should be inside the vacant space or central gap inside the permanent magnet ring.

In use of the apparatus as a dry etching device or sputtering device, it is advantageous to have the permanent magnet ring mounted at the cathode. The permanent magnet can be mounted on either the upper surface or lower surface of the cathode surrounding the material to be etched or sputtered, or it can be partly or wholly embedded within the cathode. When used as dry etching apparatus or sputtering apparatus, it is preferable that the permanent magnet be mounted by suitable means in the space above the cathode. In dry etching apparatus, in particular, the permanent magnet can be mounted on an opposing anode situated facing the cathode, or in the space between such an anode and the cathode. If mounted on the anode, the permanent magnet can be located on either the upper or lower surface of the anode, or can be partly or wholly embedded within the anode.

A preferable arrangement is to have a cathode and an anode, for the permanent magnet to surround the target material, and for the vapor-desposition substrate to be located on the anode. Another preferable configuration is to have separate permanent magnets located on the cathode and the opposing anode, with the N-poles of the two magnets facing each other. In a preferred embodiment it is advantageous to mount the permanent magnet on the anode. The permanent magnet can be mounted on either the upper surface or lower surface of the anode surrounding the vapor-deposition substrate, or it can be partly embedded within the anode.

In dry process apparatus it is preferable that the permanent magnet be also mounted by suitable means in the space above or below the anode at a distance from the anode; in the space between the cathode and the opposing anode; or at a distance from the anode in the space on the opposite side of the anode from the opposing cathode. The preferred shape of the permanent magnet ring is a circular ring, an elliptical ring, or an angular, suitably rectangular ring. It is also preferred that the permanent magnet be electrically connected to the high-frequency power supply; or be electrically grounded.

Advantageously an auxiliary magnetic member is disposed adjacent the permanent magnet to modify the magnetic field. The auxiliary magnetic member may be an magnet having an N-pole adjacent to the S-pole of the permanent magnet, and an S-pole adjacent to the N-pole of the permanent magnet. The auxiliary magnetic member may alternatively be of a ferromagnetic material having no coercive-power. The auxiliary magnetic member may also be in the form of a ring extending along a permanent magnet. The permanent magnet ring generates a magnetic field in an arbitrary desired space above the material to be processed inside the reactor. A plasma is created of high density and uniformity above the material to be processed, permitting processing at a fast rate with high uniformity. It is believed that since the magnetic field can be oriented essentially parallel to the surface of the material to be processed, electrons in the plasma do not tend to drift onto the material, so an ion sheath does not tend to form, and the self-bias voltage is reduced by a factor of approximately five or more with attendant reductions in the damage to the material caused by ion bombardment.

In embodiments in which the permanent magnet is mounted separately from the cathode or anode, or is embedded in the cathode or anode and does not protrude from the surface of the cathode or anode on the same side as the material to be processed, the flow of etching or sputtering gas or of chemical vapor-deposition gas over the surface of the material can be improved, so that the high density plasma created by the magnetron discharge can be supplied with good uniformity to the material to be processed.
Figures 1A and 1B are schematic drawings of the prior art dry etching apparatus;
Figures, 2A and 2B are a plan view and cross-sectional view along line IIB-IIB in Figure 2A of a permanent ring magnet of an embodiment of the invention;
Figure 3A is a schematic diagram of a dry process apparatus of the invention;
Figures 3B through 3D illustrate alternative mountings of the permanent ring magnet;
Figure 4A is a schematic diagram of another dry process apparatus of the invention;
Figures 4B through 4D illustrate alternative mountings of the the permanent ring magnet;
Figures 5,6,7,8,9 and 10A are schematic diagrams of further dry process apparatus's of the invention;
Figures 10B through 10F illustrate alternative mountings of the permanent ring magnet;
Figure 11 is a schematic diagram of a further dry process apparatus of the invention;
Figures 12A and 12B shows plan view and section of an example of a magnet assembly including an auxiliary magnetic member;
Figure 12C shows the manner of forming the magnetic assembly of Figures 12A and 12B:
Figures 13A, 13B, 14A, 14B, 15A, 15B, 16A, 16B, 17A and 17B show further examples of magnet assemblies which can be used in place of the magnet alone in the various embodiments of the invention;
Figure 18 shows an arrangement for rotating the permanent magnet of a dry process apparatus of the inventors.

In the drawings, which are by way of example only, components identical to components shown in Figures 1A and 1B have the same reference numbers, and are not described in detail. The examples relate mainly to dry etching apparatus, but sputtering apparatus, and chemical vapor-deposition apparatus can be constructed analogously. An important improvement incorporated in the examples concerns the permanent magnet and its mounting.

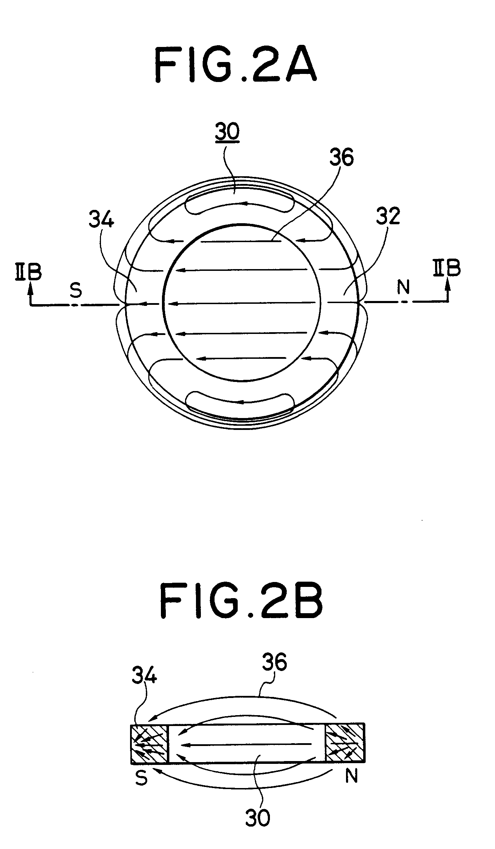

One preferred example (Figures 2A,2B) of permanent magnet 30 is shaped as a circular ring and is divided diametrically into two sections, which are magnetized so that the magnetic N-pole 32 is located in one section and the magnetic S-pole 34 is located in the other. Lines of magnetic force 36 (indicated in the drawings by solid lines with arrows) extend from the N-pole to the S-pole, mainly in the vacant space within the ring and in the adjoining space. In plan view these lines of force 36 are substantially parallel and are of substantially uniform intensity. The circular shape is only one possible shape Square, rectangular, and elliptical shapes may also be suitable.

The annular magnet with laterally spaced pole sectors may be incorporated in different ways in the apparatus.

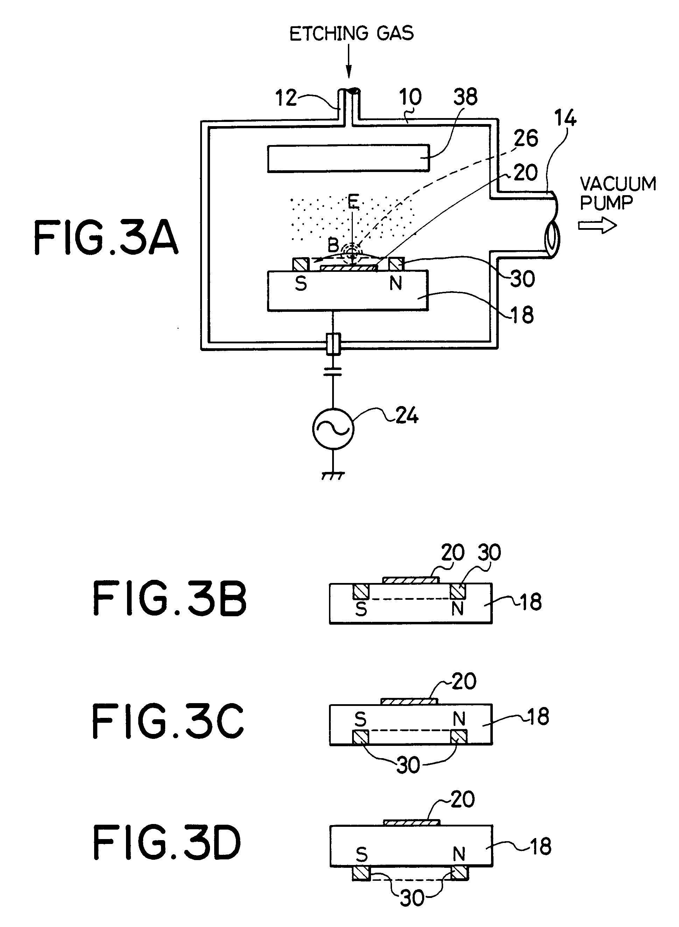

In one embodiment (Figures 3A to 3D) the magnet 30 is attached to the cathode 18 which faces a grounded anode 38 inside the reactor 10. The magnet 30 is mounted on the surface of the cathode 18 facing the anode 38. The material to be etched, such as a substrate (or wafer) 20, is placed inside the ring which may surround the substrate 20.

When 13.56MHz electromagnetic waves are applied to the cathode 18 a high-frequency alternating electric field E is produced in the space above the cathode 18, oriented substantially perpendicular to the cathode 18 and, hence the substrate 20. This field E interacts with the field B formed between the N- and S-poles of the permanent magnet 30 to induce a magnetron discharge 26 (indicated by dashed circles). The plasma intensity in the region of this magnetron discharge 26 is proportional to the intensity of the alternating electric field E and the intensity of the magnetic field B. Since both the alternating electric field E and the magnetic Field B have substantially uniform intensity distributions over the substrate 20, the plasma intensity is also substantially uniform. The ionization rate of the magnetron discharge of the plasma is at least two orders of magnitude higher than the ionization rate of an rf discharge. The etch rate of the device in this embodiment is therefore at least one order of magnitude higher than in the prior art, and the etching is highly uniform. The permanent magnet 30 can be mounted also as shown, for example, in Figs, 3B through 3D. with the permanent magnet 30 embedded in the cathode 18 on the same side as the substrate 20 (Figure 3B) or embedded in the cathode 18 on the opposite side of the substrate 20 (Figure 3C) or mounted on the surface of the cathode 18 on the opposite side of the substrate 20 (Figure 3D). The permanent magnet can also be mounted at a distance from the cathode 18. In any of these positions, the permanent magnet is able to generate a substantially uniform, parallel magnetic field orthogonally intersecting an alternating electric field in a suitable region of space inside the reactor adjacent to the substrate. The mounting configurations shown in Figures 3B through 3D may improve the flow of etching gas over the substrate surface, as already explained, enabling a highly uniform high-density plasma to be produced by magnetron discharge over the substrate.

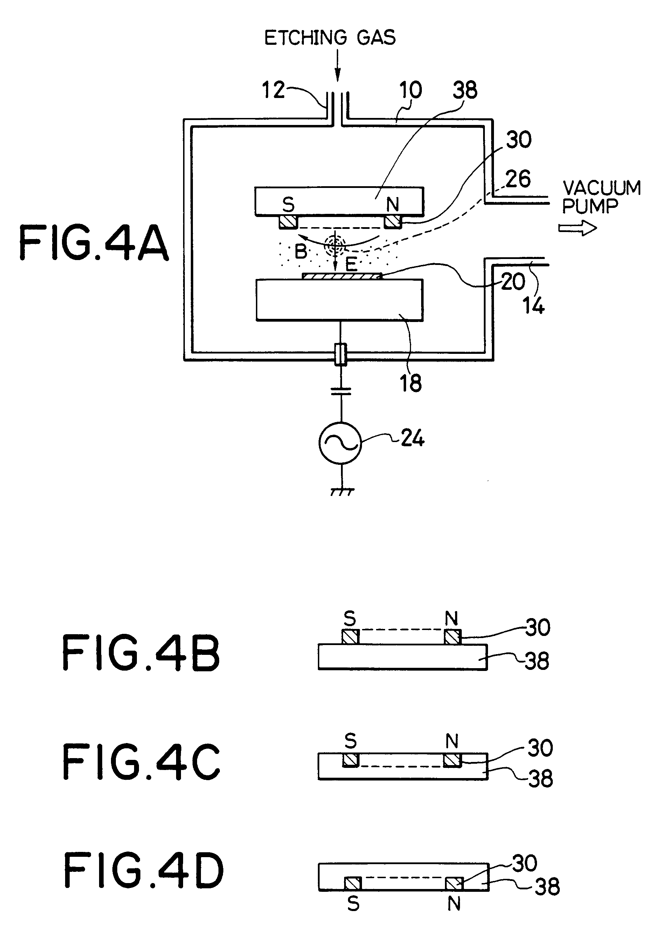

In a further embodiment (Figures 4A to 4D) the permanent magnet 30 is situated in the space above the cathode 18 and attached to the anode 38. In the configuration shown in Figure 4A the permanent magnet 30 is mounted on the surface of the anode 38 facing the cathode 18. A substantially uniform, parallel magnetic field B orthogonally intersecting an alternating electric field E is generated in the space between the anode 38 and the cathode 18, giving rise to a magnetron discharge in an appropriate region in this space. A higher density plasma can be formed by the magnetron discharge 26 in the region adjacent to the substrate surface by reducing the gap between the anode 38 and cathode 18. The flow of etching gas can be improved enabling the high-density plasma produced by the magnetron discharge to be supplied with good uniformity to the material to be etched. In this embodiment the permanent magnet 30 can also be mounted on the surface of the anode 38 away from the cathode 18 as in Figure 4B. or can be embedded in the side of the anode 38 near the cathode 18 as in Figure 4D In Figure 4B, the permanent magnet 30 can also be mounted at a distance from the anode 38.

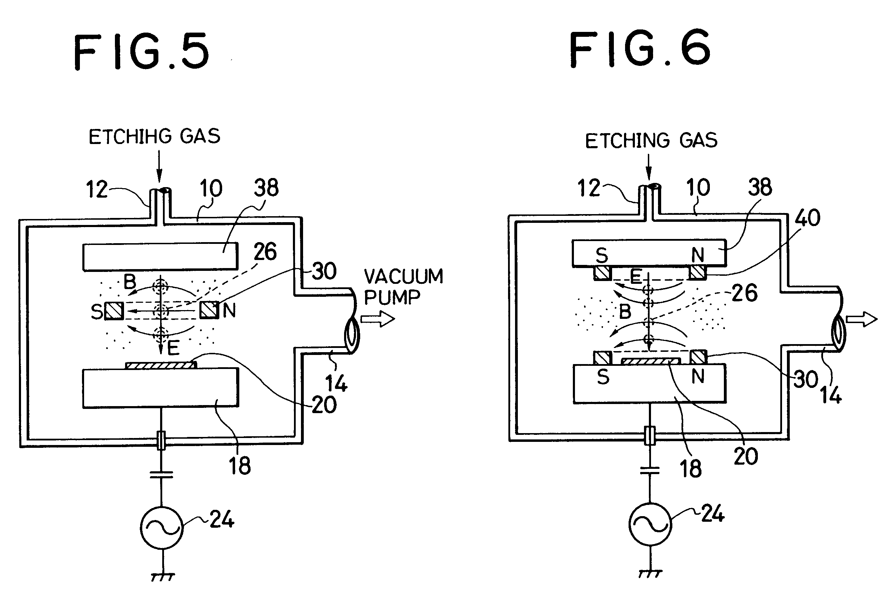

In Figure 5 the permanent magnet 30 is mounted in a space above the cathode 18 by an appropriate means (not shown in the drawing). The mutual separation of the cathode 18, the anode 38, and the permanent magnet 30 reduces etching gas turbulence over the surface of the substrate 20, improving the planar distribution of the etch rate and facilitating venting of gas produced by etching, resulting in a higher etch rate. The planar uniformity of the etch rate is affected by the electrical potential of the permanent magnet 30, which is hence an important factor. The permanent magnet 30 may be tied to the same ground potential as the anode 38, or to the same high frequency potential as the cathode 18, or left at a floating potential in which its only electrical contact is with plasma. The preferred choice is to leave the permanent magnet 30 at a floating potential, if it is desired to minimize distortion of the electric field around the permanent magnet 30.

In Figure 6 one permanent magnet 30 is mounted on the cathode 18 and another similar magnet 40 is mounted on the anode 38, on facing sides thereof. The permanent magnets 30 and 40 should preferably be positioned so that their respective S-and N-poles are opposite one another with like poles facing in the same direction. The lines of force generated repel each other, creating a more uniform magnetic field above the substrate, enabling a higher plasma density to be achieved. Etching can therefore be performed with greater speed and uniformity. The permanent magnets 30 and 40 in this example can also be mounted as shown in Figures 3B through 3D and Figures 4B through 4D.

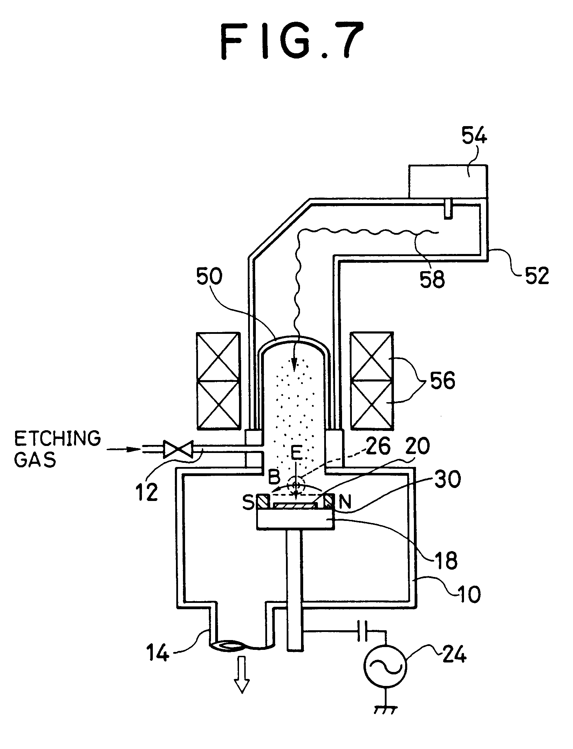

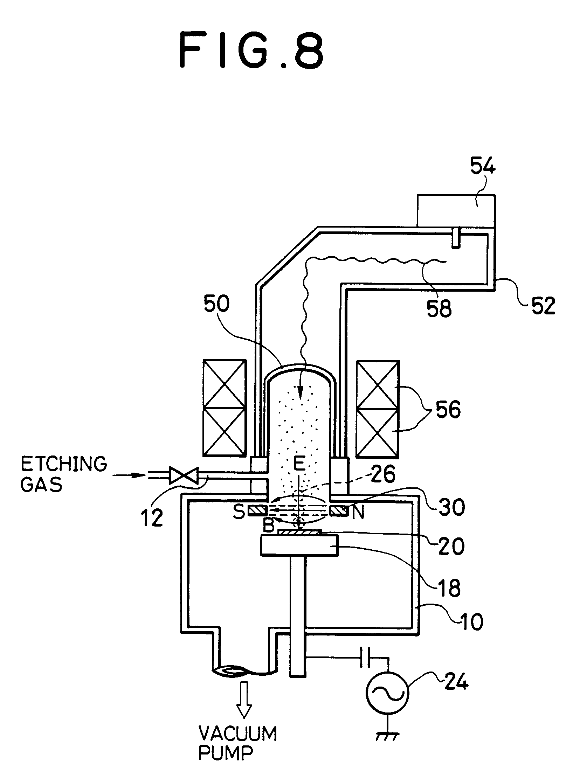

Figure 7 and Figure 8 show further embodiments in which the dry etching apparatus uses microwaves to ionize the etching gas to create a plasma. In this type of dry etching apparatus the reactor 10 itself is grounded and acts as the cathode. Again components shown in earlier drawings are given identical reference numbers and are not described in detail. First the components common Figures 7 and 8 are explained. The reactor 10 is joined to a quartz tube 50 situated above the cathode 18 and opening into the interior reactor space. The quartz tube 50 is inserted into one end of a waveguide 52, the other end of which is equipped with a magnetron 54. A solenoid coil 56 surrounds the section of the waveguide 52 containing the quartz tube 50.

In Figure 7, the permanent magnet 30 is a ring, which may be circular and mounted on the same side of the cathode 18 as the substrate. The permanent magnet 30 could, however, be mounted in any of the positions shown in Figures 3B through 3D with respect to the cathode. When this apparatus is operated, 2.45 GHz microwave radiation 58 produced by the magnetron 54 is guided by the waveguide 52 into the etching chamber formed by the quartz tube 50 attached to the reactor 10. Etching gas is introduced into the reactor 10 via the etching gas inlet 12. If an 875-Gauss magnetic field is created by the solenoid coil 56, cyclotron resonance of the electrons inside the quartz tube 50 generates an excited plasma. The diffuse magnetic field causes the plasma created inside the quartz tube 50 to flow to the substrate 20 to be etched. Application of 13.56MHz high-frequency electromagnetic waves to the cathode 18 generates an alternating electric field E oriented perpendicularly to the substrate 26 in the space over the cathode 18. As in the embodiments already described, the result is that a uniform, high-density plasma is created over the substrate, which can accordingly be etched uniformly at a high rate.

The embodiment shown in Figure 8 differs from the embodiment shown in Figure 7 in that the permanent magnet 30 is located at a distance above the cathode 18, so that the region inside and adjoining the permanent magnet ring is located over the substrate 20. The separation of the permanent magnet 30 from the substrate 20 has the effect noted in the third embodiment. The positional relation of the permanent magnet 30 and cathode 18 can also be as shown in Figures 3B through 3D.

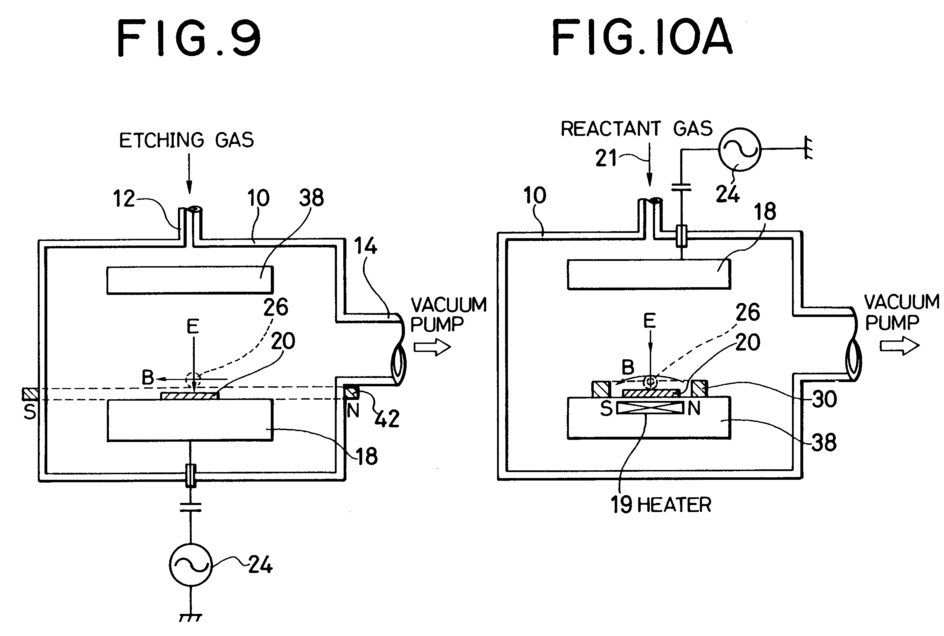

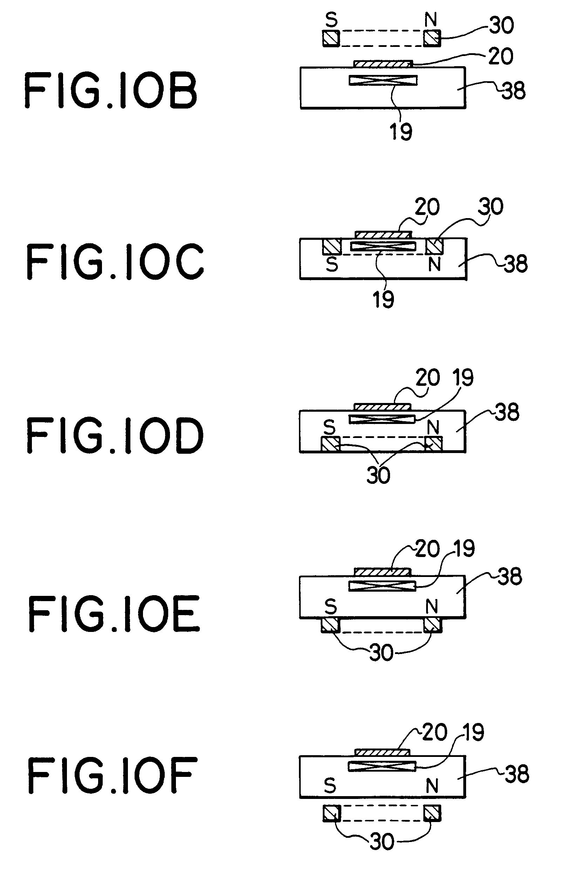

In Figure 10 A the material to be processed is a substrate 20, on which chemically reactive vapor is to be deposited, which is placed in the anode 38, to which the permanent ring magnet shown in Figures 2A and 2B is attached to produce a magnetron discharge. The anode 38 and cathode 18 are mounted facing each other inside the reactor 10, and the anode 38 is grounded. The permanent magnet 30 is mounted on the surface of the anode 38 near the cathode 18. The substrate 20 is located in the vacant permanent magnet 30 which surrounds the substrate 20. When 13.56MHz electromagnetic waves are applied to the cathode 18, a high frequency alternating electric field E is generated below the cathode 18, oriented substantially perpendicularly to the anode 38, hence to the chemical vapor-deposition substrate 20. A substantially uniform plasma density can again be achieved. Because the amode 38 is grounded, the reaction products formed in the plasma are deposited in a film. A dc bias or a high-frequency (rf) electric field can be applied to the anode 38 if it is desired to vapor-deposit a film while sputtering it with ions.

Other permanent magnet positions with respect to the anode 38 are also possible, such as those shown in Figures 10B through 10F. In Figure 10B the permanent magnet 30 is located above the surface of the anode 38 on which the substrate is placed; in Fig 10C it is embedded in the anode 38 on the same side as the substrate; in Figure 10D it is embedded in the anode 38 on the opposite side from the substrate: and in Figure 10F it is located beneath the anode 38 on the opposite side from the substrate. In any of these positions, the permanent magnet 30 is able to generate a substantially uniform, parallel magnetic field orthogonally intersecting an alternating electric field in a suitable region of space inside the reactor adjacent to the substrate. The mounting configurations shown in Figures 10B to 10F may improve the flow of reactant gas over the vapor deposition substrate surface, enabling a highly uniform high-density plasma to be produced by magnetron discharge over the substrate.

The embodiments may be modified. For example, the apparatus shown in Figure 3A to 3D, 4A to 4D, 5. and 6 can be used as a sputtering apparatus by placing the substrate on which sputtered material is to be deposited on the anode and mounting the permanent ring magnet directly on the cathode around the target placed on the cathode and/or the anode to generate a high-density plasma which enables the sputtering deposition process to proceed at a high rate. Instead of being mounted directly on the cathode, the permanent ring magnet can be mounted a slight distance above the cathode to generate a high-density plasma. This arrangement improves the flow of sputtering gas, enabling a high rate and high uniformity of sputtering deposition. The anode can be positioned at a suitable location within the reactor.

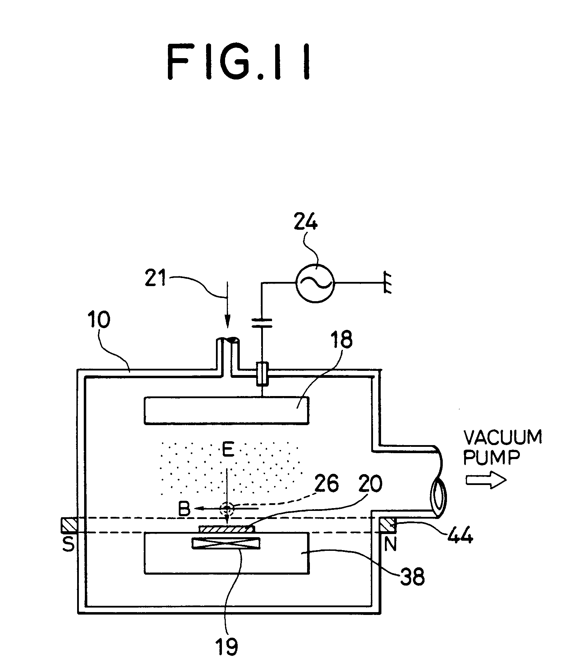

The permanent ring magnet has been situated inside the reactor, but can also be placed outside the reactor. Such a configuration is shown in Figures 9 and 11. The permanent ring magnet 42 or 44 should be located in an appropriate position outside the reactor so that the lines of force of the magnetic field B run approximately parallel to the cathode 18 or anode 38 in the space above the cathode 18 or anode 38.

In the dry process apparatus of the various embodiments described above the permanent magnets were stationary, but the permanent ring magnet can be rotated around its center of rotational symmetry or center of gravity in the plane of the ring to rotate the magnetic field in a plane substantially orthogonal to the plane of the alternating electric field. This assists more uniform plasma intensity distribution over the material to be etched, the sputtering target material, or the material on which vapor is to be desposited, leading to greater uniformity of the etch rate, sputter rate, or vapor-deposition rate. The permanent magnet may be rotated in any suitable manner. When the permanent magnet is mounted on the cathode or anode, for example, it suffices to provide means of rotating the cathode or anode without rotating the material 20. When the permanent magnet is not mounted on the cathode or anode, the support structure of the permanent magnet can be used for mechanical rotation control, or the rotation can be controlled electromagnetically from outside the reactor. The rate of rotation is not critical. When permanent magnets are mounted on both the cathode and anode as described previously, the rotation of the two magnets should be synchronized so that their S-and N-poles remain in opposition.

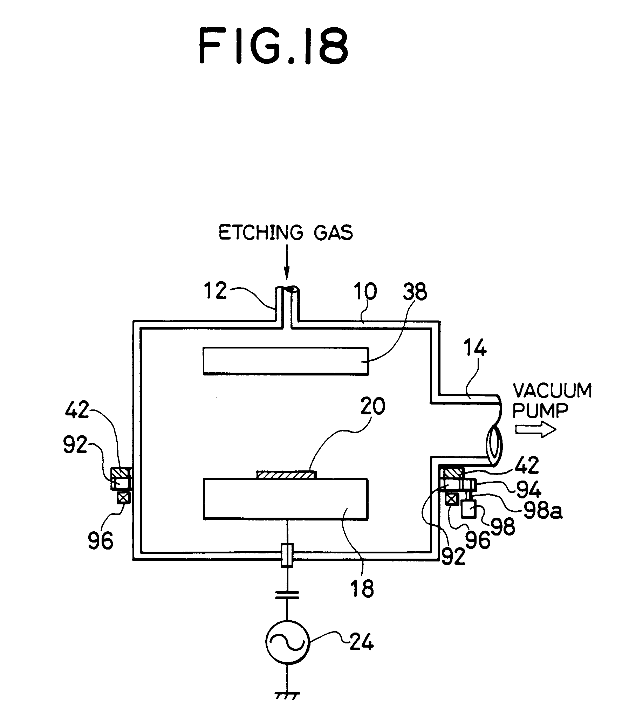

When the magnet is placed outside of the reactor, an arrangement as shown in Figure 18 can be used for rotation of the permanent magnet. The arrangement includes a first gear 92 mounting a permanent magnet 42 and a second gear 94 meshing with the first gear 92 which is supported rotatably by a bearing means 96 having a ball bearings arranged circumferentially. The second gear is drivable by a shaft 98a of a motor 98 rotating the first and second gear and hence the permanent magnet 42.

If necessary, the permanent magnet used can be electrically connected to the high-frequency (rf) power supply or can be electrically grounded to maintain the perpendicular orientation of the electric field (field vector) to the cathode.

This invention is characterised by the use of a permanent ring magnet to generate the magnetic field necessary to produce a magnetron discharge, and by the positional relationships of the magnet. The structure of other parts of the dry process apparatus can be modified to suit the design without being restricted to the structures described above.

The annular permanent magnet can be used in combination with an auxiliary magnetic member. An example of such a combination is shown in Figures 12A and 12B in which an auxiliary magnetic member 60 in ring-form is disposed inside of and in contact with ring magnet 30 to form a magnet assembly 62.

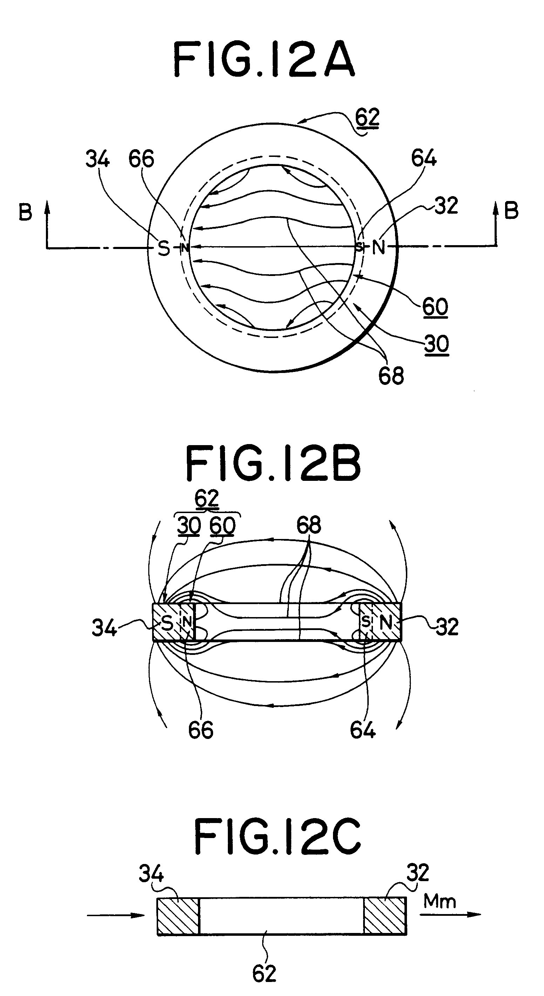

The auxiliary magnetic member 30 can be formed integrally with the magnet 30 as shown in Figures 12A and 12B. This can be produced by magnetisation using an external magnetic field Mm of an electromagnet as shown in Figure 12C, to form the N-pole 32 and the S-pole 34 of the main permanent magnet 30. Upon removal of the external magnetic field, the inside parts of the ring adjacent the N-pole 32 and the S-pole 34 of the main permanent magnet 30 are spontaneously magnetized to result in the S-pole 64 and the N-pole 66 of the auxiliary permanent magnet 60. The magnet assembly 62 is thus divided into the main permanent magnet 30 and the auxiliary permanent magnet 60, both in the form of a ring. The boundary between the magnet layers 30 and 60 are indicated approximately by the dashed line.

A suitable material which can be used for the formation of the magnet assembly 60 is alnico containing mainly Al, Ni, Co and Fe. The content of Co should preferably be about 30%. With such a high content of Co, the coercive-power is more than about 1,000 Gauss. When the content of Co is about 25%, the coercive-power is less than about 1,000 Gauss and the formation of the N-pole and the S-pole of the auxiliary permanent magnet layer 60 does not occur. With the structure as shown in Figures 12A and 12B, the lines of magnetic force induced in the central space of the ring will have an improved uniformity as seen in the plan view (Figure 12A) and as seen in cross section (Figure 12B). The lines of magnetic force 68 also have a better parallelism as seen in the cross section (Figure 12B).

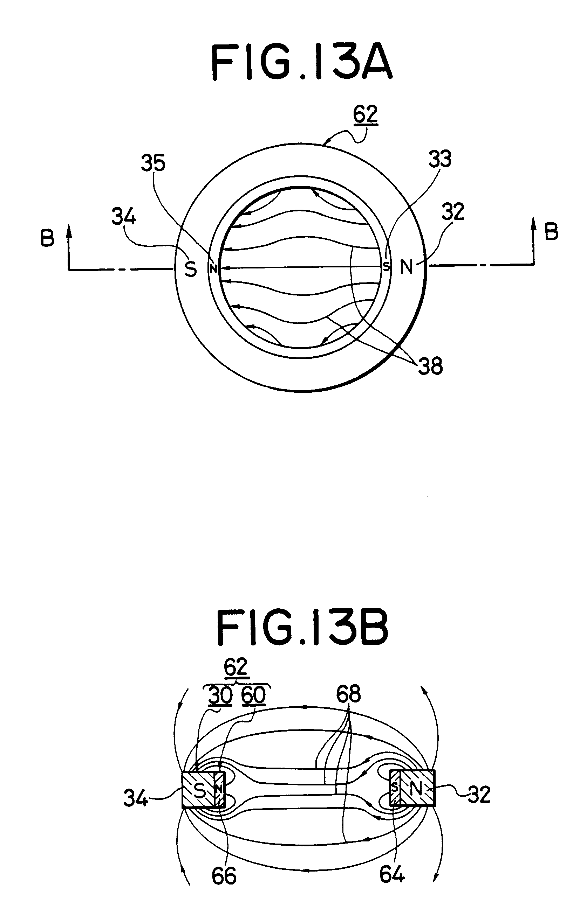

Figures 13A and 13B show another example of a magnet assembly (members and parts identical to those shown in Figures 12A and 12B are denoted by identical reference numerals) which comprises a main auxiliary permanent magnet 30 and an auxiliary permanent magnet 60 which are separately magnetized and than assembled by fitting magnet 60 in the magnet layer 30, the boundary between them being indicated by a solid line. The magnetic field due to the outer magnet layer 30, if taken alone, is more intense than the magnetic field due to the inner auxiliary permanent magnet 60 taken alone. With this structure, the coercive-power of the permanent magnet 30 or 50 is not critical. The resultant lines of magnetic force are similar to those of Figures 12A and 12B.

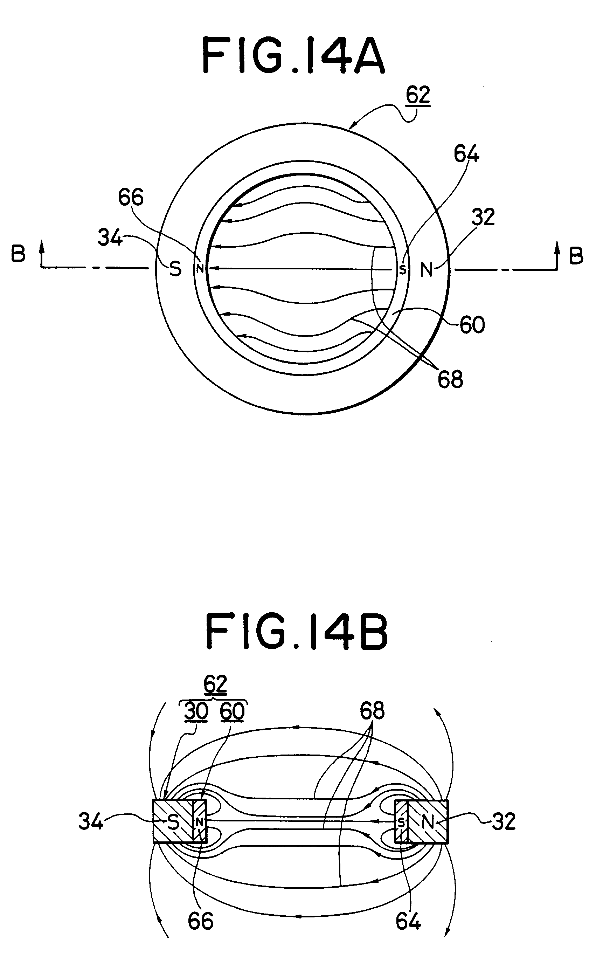

Instead of from a permanent magnet, the auxiliary magnetic member can also be made of a ferromagnetic material having no coercive-force for example iron. The assembly is shown in Figures 14A and 14B. The part of the auxiliary magnetic member 60 adjacent the N-pole 32 of the permanent magnet 30 is magnetized to exhibit an S-pole 64 on its inner peripheral surface, while the part of the auxiliary magnetic member 60 adjacent the S-pole 34 of the permanent magnet 30 is magnetized to exhibit an N-pole 66 on its peripheral surface.

The lines of the magnetic force induced by the magnet assembly of Figures 14A and 14B are similar to those shown in Figures 12A, 12B, 13A and 13B, and have an improved uniformity in the central space in the ring as seen in plan view (Fig 14A) and as seen in cross section (Figure 14B). The lines of magnetic force 68 also have a better parallelism as seen in the cross sectional view (Figure 14B). The ring permanent magnet and the ring auxiliary magnetic member can be divided into elements arranged with gaps between adjacent pieces, as long as the magnetic property and function of the assembly are maintained. The gaps may be filled with non-magnetic material which does not change the magnetic properties of the assembly.

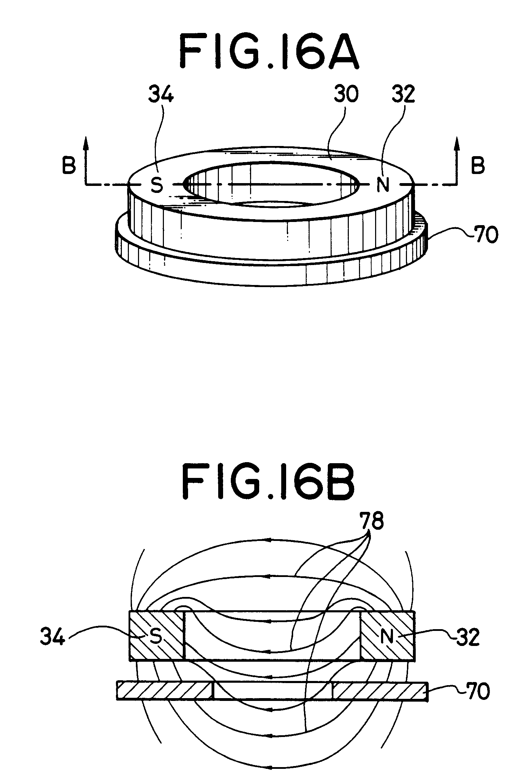

Figures 15A and 15B show another example of the magnet assembly (members or parts similar to those in Figures 14A and 4B being denoted by identical reference numerals) in which there is a radial gap between the permanent magnet 30. By varying the space between the auxiliary magnetic member 60 and the permanent magnet 30, the uniformity and intensity of the magnetic field can be adjusted. Moreover, by changing the vertical position of the auxiliary magnetic member 60 with respect of the magnetic field can also be adjusted. The uniformity and intensity of the magnetic field can be also adjusted by differentiating the shape of the auxiliary magnetic member 60 from that of the permanent magnet 30.

Figures 16A and 16B show another example of the magnet assembly in which an auxiliary magnetic member 70 has a larger outer diameter than the permanent magnet 30, and is positioned beneath the permanent magnet 30. The lines of magnetic force 78 deviate downward and the density of the lines of magnetic force 78 in the upper and central regions can be varied, by varying the relative position of the auxiliary magnetic member 70 with respect to permanent magnet 30.

Alternatively, the auxiliary magnetic member 70 can be positioned above the permanent magnet 30.

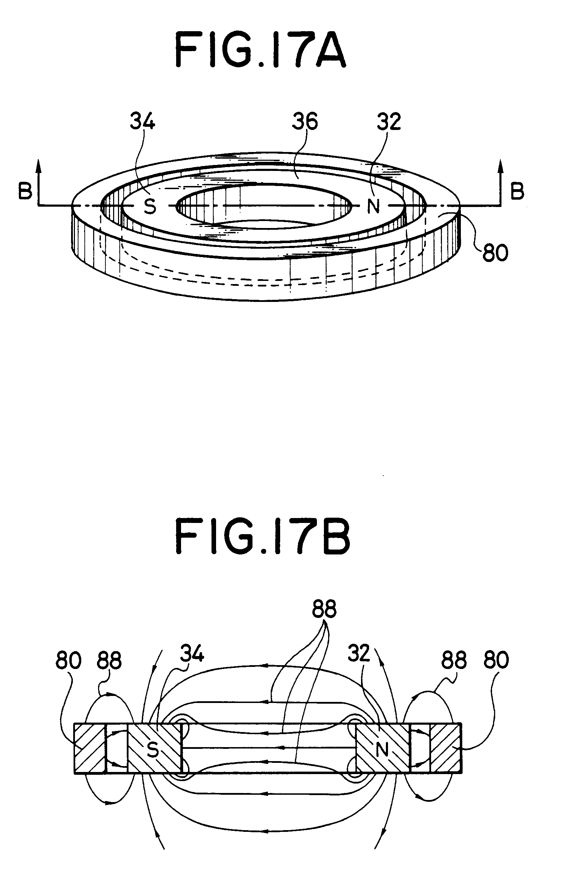

Figures 17A and 17B show a further example of the magnet assembly. In this example, an auxiliary magnetic member 80 has a larger diameter than the permanent magnet 30. There is a separation between the inner periphery of the auxiliary magnetic member 80 and the outer periphery of the permanent magnet 30. In this structure, some of the lines of magnetic force 88 circle around the auxiliary magnetic member outside the permanent magnet 30. The intensity of the magnetic field inside the permanent magnet 30 can therefore be varied.

The arrangements of Figures 16A, 16B, 17A, 17B can be employed to compensate for the difference in the strength of magnetization of the individual permanent magnets, due for example to fluctuation in the conditions under which the individual permanent magnets are fabricated. The magnet assembly described above can be used in place of the permanent magnet alone as used in the various embodiments described previously. The dry process apparatus of this invention is capable of producing a highly uniform magnetic field in the region inside and adjoining a permanent ring magnet, hence of generating a high-density plasma with a high degree of uniformity over a material to be etched, a target material, or a material on to which vapor is to be deposited. The process of etching or sputtering the material or depositing a thin film on it can therefore be accomplished at a high rate with high uniformity. Since the magnetic field produced in the dry process apparatus is oriented essentially parallel to the surface of the material to be processed, electrons in the plasma do not tend to drift onto the material, so that there is less tendency for forming an ion sheath, and the self bias voltage is reduced by a factor of five or more with an attendant reduction in the damage to the material caused by ion bombardment. The dry process apparatus of this invention is therefore particularly suited for low-damage etching, for gates that require high vapor-deposition rates, for trench etching, and for deposition of interconnecting materials. The dry process apparatus can be of compact construction.

## Claims

1. Plasma discharge dry process apparatus having a reactor (10) in which an alternating electric field can be generated by a pair of electrodes (18,38) for processing material (20) mounted on one of the electrodes, for example for etching, sputtering or depositing a thin film, and means are provided for generating a magnetic field interacting with the electrical field to induce magnetron discharge to aid processing of the material (20); characterised in that the magnetic field generating means comprises a continuous or substantially continuous magnet ring (30) of permanently magnetized material having a N-pole in one half and an S-pole in the other half with the poles arranged so as to generate substantially parallel field lines extending across the central ring gap.

2. Apparatus according to claim 2 characterised in that the magnet ring (30) is continuous, optionally circular, elliptical or angular and the respective poles (32,34) are formed on transversely spaced ends of the magnet ring (30), preferably on diametrically opposed ends.

3. Apparatus as claimed in any of the preceding claims characterised in that the magnet ring (30) is disposed to produce the magnetic field substantially parallel to the surface of a first electrode (18) for locating above the material (20) to be processed, preferably by being disposed to extend in a plane parallel to the first electrode (18) surface.

4. Apparatus as claimed in any of the preceding claims characterised in that the magnet ring (30) is mounted inside or outside the reactor (10) and in a stationary manner or rotatable in a plane parallel to the surface of the material (20) to be processed.

5. Apparatus as claimed in any of the preceding claims characterised in that the magnet ring (30) is mounted below, embedded in either the top or the bottom of, mounted on or mounted spaced from the electrode (18) on which the material (20) is to be supported, in which later case the magnet ring (30) may be mounted on the other electrode or in the space between the pair of electrodes.

6. Apparatus as claimed in any of the preceding claims in which a pair of magnet rings (30,40) serves to the generate the magnetic field with the respective N-poles and S-poles being aligned, with preferably one magnet ring (30) being on the electrode mounting the material (20) and the other magnet ring (40) being on the other electrode.

7. Apparatus according to any of the preceding claims in which one magnet ring (30) is or both magnet rings (30,40) are associated with an auxiliary magnetic member for modifying the magnet field, which auxiliary magnetic member may be of permanent magnet material, integral with or distinct from the material of the magnet ring 30, or of ferromagnetic material of substantially no coercive force; may be in the form of a ring extending along said permanent magnet ring (30), radially inward or outward, or axially above or below; either contiguous with the magnet ring (30) or spaced therefrom; and may have an N-pole adjacent the S-pole of the magnet ring (30) and vice versa.

8. Apparatus according to any of the preceding claims characterised in that the magnet ring (30) is electrically connected to the high frequency power supply, is electrically grounded, or is at a floating potential

9. Apparatus according to any of the preceding claims characterised in that the electrode, not connected to a high frequency power supply, is electrically connected to a dc or rf power supply.

10. A method of use of the apparatus according to any of the preceding claims in which material to be processed is placed either inside the magnet ring (30), or axially spaced from the plane of the magnet ring (30) and inside the linear projection of the central gap of the magnet ring (30).

## Patentansprüche

1. Vorrichtung für einen Plasmaentladetrockenprozeß mit einem Reaktor (10), in dem ein elektrisches Wechselfeld durch ein Paar von Elektroden (18, 38) erzeugt werden kann, um ein auf einer der Elektroden (18, 38) angebrachtes Material (20) beispielsweise zum Ätzen, Kathodenzerstäuben oder Abscheiden eines dünnen Filmes zu bearbeiten, und Mittel zum Erzeugen eines mit dem elektrischen Feld in Wechselwirkung stehenden magnetischen Feldes vorgesehen sind, um zur Unterstützung des Bearbeitens des Materials (20) eine Magnetronentladung zu induzieren, dadurch gekennzeichnet, daß die Mittel zum Erzeugen des magnetischen Feldes einen kontinuierlichen oder im wesentlichen kontinuierlichen Magnetring (30) aus permanentmagnetischen Material mit einem N-Pol in einer Hälfte und einem S-Pol in der anderen Hälfte aufweisen, bei dem die Pole so angeordnet sind, daß quer durch die zentrale Ringöffnung sich erstreckende, im wesentlichen parallele Feldlinien erzeugt werden.

2. Vorrichtung nach Anspruch 2, dadurch gekennzeichnet, daß der Magnetring (30) kontinuierlich, wahlweise ringförmig, elliptisch oder eckig ist und die jeweiligen Pole (32, 34) auf transversal voneinander beabstandeten Enden des Magnetringes (30) ausgebildet sind, vorzugsweise auf diametral gegenüberliegenden Enden.

3. Vorrichtung nach einem der vorangegangenen Ansprüche, dadurch gekennzeichnet, daß der Magnetring (30) zum Erzeugen des Magnetfelds im wesentlichen parallel zur Oberfläche einer ersten Elektrode (18) angeordnet ist, um es über dem zu bearbeitendem Material (20) zu plazieren, vorzugsweise so, um sich in einer Ebene parallel zur Oberfläche der ersten Elektrode (18) zu erstrecken.

4. Vorrichtung nach einem der vorangegangenen Ansprüche, dadurch gekennzeichnet, daß der Magnetring (30) innerhalb oder außerhalb des Reaktors (10) und in einer feststehenden Weise oder drehbar in einer Ebene parallel zur Oberfläche des zu bearbeitenden Materials (20) montiert ist.

5. Vorrichtung nach einem der vorangegangenen Ansprüche, dadurch gekennzeichnet, daß der Magnetring (30) entweder unterhalb der Elektrode angebracht ist oder entweder in die Oberseite oder die Unterseite der Elektrode eingebettet ist oder auf der Elektrode oder beabstandet von der Elektrode (18) angebracht ist, auf der das Material (20) gehaltert werden soll, wobei in letzterem Fall der Magnetring (30) auf der anderen Elektrode oder im Raum zwischen den beiden Elektroden angebracht sein kann.

6. Vorrichtung nach einem der vorangegangenen Ansprüche, bei der zwei Magnetringe (30, 40) dazu dienen, das Magnetfeld mit den ausgerichteten jeweiligen N-Polen und S-Polen zu erzeugen, wobei sich vorzugsweise ein Magnetring (30) auf der das Material (20) befestigenden Elektrode und sich der andere Magnetring (40) auf der anderen Elektrode befindet.

7. Vorrichtung nach einem der vorangegangenen Ansprüche, bei der ein Magnetring (30) oder beide Magnetringe (30, 40) mit einem Zusatzmagnetelement in Verbindung stehen, um das Magnetfeld zu modifizieren, wobei das Zusatzmagnetelement aus einem Permanentmagnetmaterial bestehen kann, das gleich oder verschieden vom Material des Magnetringes (30) ist oder aus ferromagnetischem Material mit im wesentlichen keiner Koerzitivkraft besteht, die Form eines sich entlang des Permanentmagnetringes (30) radial nach innen oder außen oder axial oberhalb oder unterhalb erstreckenden Ringes haben kann, entweder sich an den Magnetring (30) anschließend oder davon beabstandet, und einen N-Pol aufweisen kann, der benachbart zum S-Pol des Magnetringes (30) ist und umgekehrt.

8. Vorrichtung nach einem der vorangegangenen Ansprüche, dadurch gekennzeichnet, daß der Magnetring (30) elektrisch mit der Hochfrequenzspannungsquelle verbunden ist und elektrisch auf Massepotential oder auf einem floatendem Potential liegt.

9. Vorrichtung nach einem der vorangegangenen Ansprüche, dadurch gekennzeichnet, daß die nicht mit einer Hochfrequenzspannungsquelle verbundene Elektrode elektrisch an eine Gleichspannungs- oder Hochfrequenzspannungsquelle angeschlossen ist.

10. Verfahren zur Verwendung der Vorrichtung nach einem der vorangegangenen Ansprüche, bei dem das zu bearbeitende Material entweder innerhalb des Magnetringes (30) angeordnet wird oder axial von der Ebene des Magnetringes (30) beabstandet und innerhalb der linearen Projektion der zentralen Öffnung des Magnetringes (30).

## Revendications

1. Appareil à procédé par voie sèche à décharge de plasma ayant un réacteur (10) lequel un champ électrique alternatif peut être généré par une paire d'électrodes (18, 38) afin de traiter une matière (20) montée sur une des électrodes, par exemple pour gravure, pulvérisation ou dépôt d'un film mince, et des moyens sont prévus pour générer un champ magnétique interagissant avec le champ électrique afin d'induire une décharge de magnétron afin d'aider le traitement de la matière (20); caractérisé en ce que les moyens de génération de champ magnétique comportent un anneau aimanté continu ou sensiblement continu (30) de matière magnétisée de façon permanente ayant un pôle N dans une moitié et un pôle S dans l'autre moitié avec les pôles disposés de façon à générer des lignes de champ sensiblement parallèles s'étendant en travers de l'espace d'anneau central.

2. Appareil selon la revendication 1, caractérisé en ce que l'anneau aimanté (30) est continu, éventuellement circulaire, elliptique ou angulaire, et les pôles respectifs (32, 34) sont formés sur des extrémités espacées transversalement de l'anneau aimanté (30) de préférence sur des extrémités diamétralement opposées.

3. Appareil selon l'une quelconque des revendications précédentes, caractérisé en ce que l'anneau aimanté (30) est disposé afin de produire le champ magnétique sensiblement parallèlement à la surface d'une première électrode (18) destinée à être positionnée au-dessus de la matière (20) devant être traitée, de préférence en étant disposée de façon à s'étendre dans un plan parallèle à la surface de la première électrode (18).

4. Appareil selon l'une quelconque des revendications précédentes, caractérisé en ce que l'anneau aimanté (30) est monté à l'intérieur ou à l'extérieur du réacteur (10) et d'une manière fixe ou rotative dans un plan parallèle à la surface de la matière (20) devant être traitée.

5. Appareil selon l'une quelconque des revendications précédentes, caractérisé en ce que l'anneau aimanté (30) est monté sous, logé dans la partie supérieure ou bien le fond, monté sur ou monté de manière espacée de l'électrode (18) sur laquelle la matière (20) doit être supportée, l'anneau aimanté (30) pouvant dans ce dernier cas être monté sur l'autre électrode ou dans l'espace entre la paire d'électrodes.

6. Appareil selon l'une quelconque des revendications précédentes, dans lequel une paire d'anneaux aimantés (30, 40) sert à générer le champ magnétique avec les pôles N et les pôles S respectifs qui sont alignés, avec de préférence un anneau aimanté (30) qui est sur l'électrode supportant la matière (20) et l'autre anneau aimanté (40) qui est sur l'autre électrode.

7. Appareil selon l'une quelconque des revendications précédentes, dans lequel un anneau aimanté (30) ou bien les deux anneaux aimantés (30, 40) sont associés à un élément magnétique auxiliaire afin de modifier le champ magnétique, lequel élément magnétique auxiliaire peut être dans une matière aimantée permanente, d'un seul tenant avec ou bien distincte de la matière de l'anneau aimanté (30), ou dans une matière ferromagnétique sans force coercitive; peut être sous la forme d'un anneau s'étendant le long dudit anneau aimanté de façon permanente (30), radialement à l'intérieur ou à l'extérieur ou axialement au-dessus ou en dessous; contigu à l'anneau aimanté (30) ou espacé de celui-ci; et peut avoir un pôle N adjacent au pôle S de l'anneau aimanté (30) et vice versa.

8. Appareil selon l'une quelconque des revendications précédentes, caractérisé en ce que l'anneau aimanté (30) est électriquement relié à l'alimentation haute fréquence, est électriquement à la masse, ou est un potentiel flottant.

9. Appareil selon l'une quelconque des revendications précédentes, caractérisé en ce que l'électrode, qui n'est pas reliée à l'alimentation haute fréquence, est électriquement relié à une alimentation haute fréquence ou à courant continu.

10. Procédé d'utilisation de l'appareil selon l'une quelconque des revendications précédentes, dans lequel de la matière devant être traitée est placée à l'intérieur de l'anneau aimanté (30), ou bien est axialement espacée du plan de l'anneau aimanté (30) et à l'intérieur de la projection linéaire de l'espace central de l'anneau aimanté (30).
